Europäisches Patentamt

European Patent Office

Office européen des brevets

(11) Publication number: **0 335 288 A2**

## EUROPEAN PATENT APPLICATION

(21) Application number: 89105343.1

(22) Date of filing: 25.03.89

(51) Int. Cl.4: **H01L 21/31 , G01N 22/00**

(30) Priority: 26.03.88 JP 72659/88

(43) Date of publication of application:
04.10.89 Bulletin 89/40

(84) Designated Contracting States:
DE FR GB

(71) Applicant: **Shin-Etsu Handotai Company, Limited**
**Togin Building 4-2, 1-chome, Marunouchi**
**Chiyoda-ku Tokyo 100(JP)**

(72) Inventor: **Ito, Taizo**
**2-6-25, Kajino-cho**
**Koganei-shi Tokyo 184(JP)**
Inventor: **Abe, Takao**
**477-19, Yanase**
**Annaka-shi Gunma 379-01(JP)**

(74) Representative: **Schneck, Herbert, Dipl.-Phys., Dr. et al**
**Rau & Schneck Patentanwälte Königstrasse 2**
**D-8500 Nürnberg 1(DE)**

(54) **A method to evaluate the homogenization of the properties across the silicon surface region of an oxidized silicon wafer.**

(57) The present invention is designed to offer a practical and simple evaluation method to determine the optimal conditions for annealing of the oxidized silicon substrate in nitrogen atmosphere, in the stabilization and homogenization process of the properties of oxidation film silicon substrate of semiconductor device having MOS structure. The degree of stabilization and homogenization of the properties is evaluated by measuring the life time of the thermally oxidized silicon substrate, as it is annealed in nitrogen atmosphere.

FIG. 2

## TITLE OF THE INVENTION

A method to evaluate the stabilization and homogenization of the properties across the silicon surface region of an oxidized silicon wafer

## BACKGROUND OF THE INVENTION

### Field of the Invention

The present invention relates to a practical method to evaluate the annealing conditions of oxidation film silicon substrate in nitrogen gas atmosphere used in the process for the stabilization and homogenization of the properties of the interface between a silicon substrate and a silicon oxide film thereon in a semiconductor device having MOS structure.

### Description of the Prior Art

In the technique to manufacture semiconductor IC devices, MOS structure plays an important role.

In MOSFET, which is a typical device having MOS structure, a thin opposite conductive type layer (inversion layer) to that of substrate is formed in the surface thereof, and the conductance of this thin layer is controlled by the electric field applied perpendicularly to this surface. The carrier contributing to the conductance is the majority carrier in the inversion layer, and the movement of the carrier is the drift by the electrical field. The electrical field applied on the substrate is applied through $SiO_2$ film. Thus, input impedance is almost completely capacitive. Since the carrier in the inversion layer flows along the interface, the mobility is smaller than that of bulk crystal, and this is the disadvantageous point of this device in comparison with a bipolar transistor. However, with the progress of the manufacturing technique in recent years including the improvement of the properties in the interface, high-speed processing is now achievable, and MOS structure, therefore, is now a core technique of LSI industry.

In MOS structure, there are various causes to make the interface-related properties unstable. One of such causes is the fact that the interface region between a silicon oxide film and a silicon substrate surface has a microscopically complicated structure. Although the silicon oxide film for semiconductor IC device, a thermally oxidized film is generally used from various technical reasons, the interface is not satisfactorily flat on the atom level. There is a transition layer between silicon atom layer in silicon substrate and $SiO_2$ layer of thermally oxidized film. It is reported that there exist, in this transition layer, a mixed layer of Si and $SiO_2$ by one or a layer of $SiO_2$ with thickness ranging from 0.1 to 2 nm by another when measured by transmission electronic microscope, X-ray photoelectron spectrometry, Auger electron spectrometry, etc.

When silicon crystal is cleaved in a high vacuum, Si bond cut Off by such cleavage is about $10^{15}/cm^2$. In contrast, the surface level of the silicon surface at the interface between a thermally oxidized film and a silicon substrate is far smaller than that and it is sometimes as low as $10^{10}/cm^2$. The surface level depends upon the irregularities of crystal lattice caused by the cutting of Si crystal bond at the interface. The surface level at the silicon interface with the thermally oxidized film also depends upon crystal orientation, whereas it is known that it is also affected by various types of contamination, crystallographic defects of silicon substrate surface and the forming condition of oxidized film.

To measure the stability of MOS structure, e.g. the stability of MOSFET property, the relation between the gate capacitance and the gate voltage (i.e. C-V characteristics) is generally used. When hysteresis appears in C-V characteristics, it is caused by time lag between the capture at surface level or traps in oxidized film and the exchange of electrons with semiconductor substrate. Specifically, this means the instability of the device characteristics. The ions in the oxidized film or its polarization also changes C-V characteristics.

As the means to reduce the surface level and various crystal defects at the interface, annealing in nitrogen gas atmosphere or hydrogen gas atmosphere is conventionally adopted, and the satisfactory effects have been obtained. For example, in the Japanese provisional patent publication No. 54-102964, a method is proposed where the surface property is stabilized by the annealing in the inert nitrogen gas or argon gas atmosphere for the damaged semiconductor surface after the manufacturing process such as plasma etching, or ion implantation, etc. However, the disclosure only relates to the annealing itself in the insert gas, and it did not propose a simple method to measure or evaluate the stabilization.

As the measure for stabilization of an oxidized silicon substrate surface property at the interface between oxidized film and silicon substrate, the decrease of surface level and its stabilization are useful. To measure the surface level, Nicollian et al. proposed the measurement of conductance of MOS structure together with its C-V curve in B.S.T.J. (Vol. 46, p. 1055) (1967). This is excelled in principle because only the surface level is considered to affect the conductance, whereas some corrections are required for capacity curve, and the technique is not necessarily simple to put into practice.

## SUMMARY OF THE INVENTION

It is an object of the present invention to offer a simple and therefore practical method to determine the optimal condition for the annealing of thermally oxidized silicon substrate in nitrogen gas atmosphere in the process for stabilization and homogenization of properties of the silicon surface at the interface of a thermally oxidized film and the silicon substrate of semiconductor device having MOS structure.

Such object can be achieved by performing thermal oxidation of semiconductor silicon substrate surface in the manufacture of semiconductor device having MOS structure, followed by proper thermal annealing thereof and by measuring the life time of said thermally oxidized substrate in the process to stabilize and homogenize the properties of the interface between the oxidized film and the substrate by annealing in nitrogen atmosphere in the manufacture of semiconductor device having MOS structure.

The measurement of life time of minority carrier is important in the design of the device, whereas it plays an important role in the evaluation of semiconductor crystals. When carriers in a semiconductor is in the state of thermal equilibrium, the product of the holes and electrons in numbers is constant. However, when carriers are generated in excess by some means, the excess electrons and the holes are recombined, and are returned to the state of equilibrium. The time of this return is the life time, and the life time of minority carrier is utilized for the evaluation of crystallinity of semiconductor. In general, it is said that, the higher the life time is, the more perfect the crystal is.

In this way, it is necessary for the restoration of equilibrium of carriers in the semiconductor that pairs of electrons and holes in excess are recombined and electrically neutralized. In the case of silicon semiconductor, this recombination is performed by:

(1) direct transition between the conduction band and the filled band, (2) the trapping center (recombination center) caused by the imperfection of the crystal, or (3) surface recombination. Among these recombinations, the recombination due to the cause of (1) is inherent and it is constant if the material is the same. In contrast, the recombination by the cause of (2) reduces life time because not only the microcrystal defects due to dislocation, crystal lattice distortion, impurities and other micro deposits but also the heavy metal elements such as Cu, Ni, Fe, etc. building up the deep impurity level form the capture center. Accordingly, unless the effects of such impurities are measured, the crystallinity evaluation of semiconductor crystal cannot be discussed only by the life time measurement. The recombination due to the cause of (3) has also very important meaning because MOS structures are formed in the surface region of silicon substrate in MOS semiconductor devices.

As described above, the life time of minority carrier is determined by three factors. But, various trapping centers on the silicon surface at the interface an oxidized film and the silicon substrate with it on can be evaluated by measuring the life time of thermal oxidation wafer according to the present inventive method.

The life time of the silicon substrate alone before thermal oxidation is extremely short (e.g. 1 $\mu$ sec or less) because the recombination rate of the surface is high. The bulk life time of silicon substrate is short in rare cases because there are a variety of recombination centers in itself even if free of dislocations. However, in most cases of single crystal, which is used as raw material for the substrate of normal semiconductor IC devices, it is 100 - 500 u sec. The life time of a thermally oxidized film wafer immediately after thermal oxidation varies according to the oxidation condition and the atmosphere during cooling. When oxidized in dry condition and cooled down in dry oxygen, it is about 10 u sec., and this is considerably lower than that of the bulk.

When silicon substrate is oxidized under wet condition or cooled down in an atmosphere with a higher humidity, e.g. at 40% relative humidity and 25°C, the life time is improved by several times in comparison with the case of dry oxidation and of the cooling in dry oxygen. The reason for this is that the moisture in the atmosphere plays a role toward the stabilization of the interface of an oxidized film and the silicon substrate with it on.

The life time is shorter than that of bulk even immediately after thermal oxidation under both dry and wet conditions. As described already, this low life time may be attributable to the fact that the surface level is still as high as 10!0/cmz although the free bond of silicon on the surface are fixed with oxygen due to thermal oxidation and stabilized. The number of free bonds on the surface by vacuum cleavage is theoretically calculated as $6.8 \times 10^{14}/cm^2$ from an atomic density on (100) plane of the crystal. Therefore, the free bonds are to be reduced by about $10^{-4}$ times by thermal oxidation.

As already described, the interface between a silicon substrate and the oxidized film is complicated. There is an intermediary transition region of about 0.1 - 2 nm, and it is quite imaginable that a number of silicon bonds remain disconnected.

The present inventors have confirmed that, when thermally oxidized silicon substrate is annealed in a nitrogen atmosphere, the life time is surprisingly improved, and that it becomes closer to the life time of the bulk. It is not yet determined how the surface level is actually changed, but it is believed that surface level has disappeared almost completely due to the observed life time improvement and what's more, the value is close to that of the bulk.

Thus, the fact that the life time becomes closer to that of the bulk means that the recombination center of the interface is at least on the bulk level. Accordingly, there seems to be no further improvement for the stabilization of interfacial property.

To measure the life time, it is preferrable to use the microwave method, which is a non-contact method. There are two methods: the method to detect the transmitted microwave and the method to detect the reflected microwave. The latter has wide applications because it has no limit to wafer shape and specimens with relatively low resistivity can be measured. The measurement system consists of an injection system to excite excess carrier and a microwave system to detect the change of conductivity of semiconductor substrate. To put it concretely, it is a method, wherein microwave is steadily irradiated on the surface of said semiconductor substrate, the intensity of the reflected wave or transmitted wave is detected, the carrier is generated in said substrate by irradiating optical pulse to said irradiated portion during irradiation of said microwave, and said life time is measured based on the changes in said detected intensity due to the irradiation of said optical pulse. The calculation of the life time by this method is described in "Oyo Butsuri" (Applied Physics), Vol. 49, No. 12, 1980, pp. 1192 - 1197. The present method is to obtain a synthetic value r m of a life time of the bulk $\tau b$ and a life time of the surface rs, and these are expressed by the following equation: $1/\tau m = 1/\tau b + 1/\tau s$

If $\tau s$ becomes extremely bigger than $\tau b$, $1/\tau s$ is negligible. Thus, $\tau m = \tau b$.

Also, if $\tau s = \tau b$, $\tau m$ becomes 1/2 of $\tau b$.

As described later by embodiment, the life time of a thermally oxidized silicon substrate is 100 u sec. or more, and it appears that the status of the interface is closer at least to the crystalline property of the bulk.

The status of the interface between an oxidized film and a silicon substrate differs according to the oxidation condition, the annealing condition of nitrogen atmosphere and the property of the bulk and surface of silicon substrate. The measured value of life time, when stabilization by nitrogen is achieved to full extent, differs according to the interfacial status. However, the annealing condition in nitrogen atmosphere seems to become optimal when the measured value of life time reaches the same level as the bulk and further improvement is not achieved. When annealed in such nitrogen atmosphere, C-V characteristics of the device with MOS structure was stabilized, and the fluctuation in threshold voltage of MOSFET diminished to half compared with those not yet annealed.

As described in the experiment example later, the cause of the improvement of life time of thermally oxidized silicon substrate in a nitrogen atmosphere is that nitrogen atoms are bonded to Si atoms with at least an uncoupled bond in the silicon surface and the surface is stabilized because nitrogen is diffused in silicon bulk through the oxidized film and reach the sites where uncoupled bonds are located.

By the measurement of a life time, it is possible to determine and evaluate the degree of stabilization and homogenization of the surface of a silicon substrate at the interface between the thermally oxidized film and the silicon. Also, the life time can be measured in non-destructive way if a microwave is used. The measured values can be easily read, and this method is very practical for the application in the in-line check in the manufacturing process of semiconductor IC elements.

## BRIEF DESCRIPTION OF THE DRAWINGS

Fig. 1 to Fig. 3 show the results of the experiments, which form the basis of the present invention.

Fig. 1 is a graphic representation of nitrogen concentration in relation to the depth from oxidation film surface of Si wafer.

Fig. 2 is the bar graph to indicate the life time of a Si wafer under the experimental conditions A - F of Table 1.

Fig. 3 is a line graph to indicate the resistivity of a Si wafer under the above experimental conditions A - F.

## DESCRIPTION OF THE PREFERRED EMBODIMENT

In the following, the features of the present invention will be described in conjunction with two experimental examples.

(1) Experiment 1

Thermally oxidized film was formed on a Si wafer surface. Then, the Si wafer was annealed in N2 atmosphere (hereinafter referred as "$N_2$ anneal"), and N concentration distribution in the Si wafer before and after $N_2$ anneal was quantitatively analyzed. For the quantitative analysis, the secondary ion mass spectrometry (SIMS) was employed. The experimental conditions are given in Table 1.

Table 1

| A | $1000^\circ$ C, dry $O_2$, 20 min. |
|---|---|
| B | A + $900^\circ$ C, $N_2$ 6$\ell$/min, 1 hour |
| C | A + $1000^\circ$ C, $N_2$ 6$\ell$/min, 1 hour |
| D | A + $1100^\circ$ C, $N_2$ 6$\ell$/min, 1 hour |
| E | A + $1200^\circ$ C, $N_2$ 6$\ell$/min, 1 hour |
| F | $1000^\circ$ C, $O_2$ 3$\ell$/min, $N_2$ 3$\ell$/min, 20 min. |

In this table, F shows the data when $O_2$ anneal and $N_2$ anneal are performed at the same time without forming oxidation film in advance (hereinafter referred as "the case of $N_2$ + $O_2$ anneal"). It will be discussed in the Experiment 2 later. A shows an oxidation condition, and in this case an oxidized film with a thickness of 250 - 650 Å was formed on the surface of the Si wafer surface. "A + " in the columns B - E indicates the oxidation film was formed on the Si wafer surface under the above condition A in advance of the $N_2$ anneal.

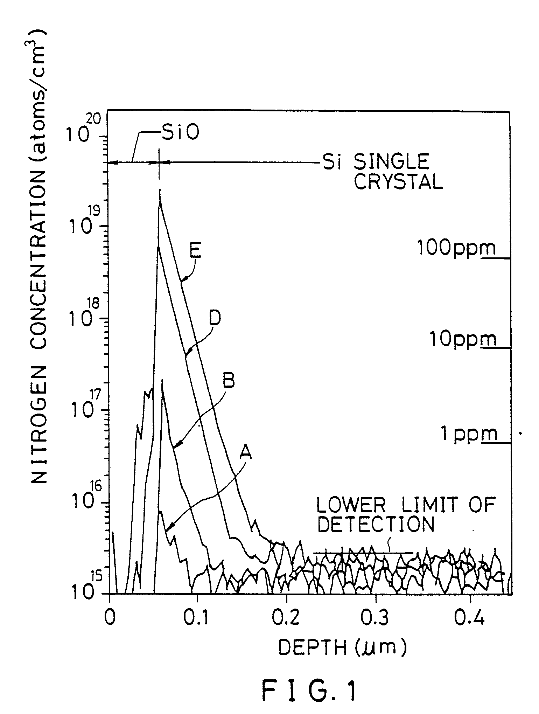

The results of the experiment are summarized in Fig. 1. In this figure, the axis of abscissa indicates the depth from the surface of the oxidized film, and the unit is um. The axis of ordinate indicates nitrogen concentration, and the unit is atoms/cm$^2$. The conditions of the experiment curves A - E correspond to the alphabets A - E of Table 1.

It was found that the interface of Si and $SiO_2$ agree well with the peak positions of the experiment curves A - E. From this figure, it is evident that the nitrogen in the atmosphere penetrates and is diffused through $SiO_2$ film, and that nitrogen is built up at high concentration near the interface between Si and $SiO_2$ and in the Si side of the interface.

This concentration is higher when the annealing temperature becomes higher.

The curve A indicates that the nitrogen originally existing in Si substrate is transferred and concentrated near the above interface.

(2) Experiment 2

Next, it was evaluated what kind of influence the nitrogen, concentrated near the interface of Si and $SiO_2$, exerts on the life time and resistivity of wafer.

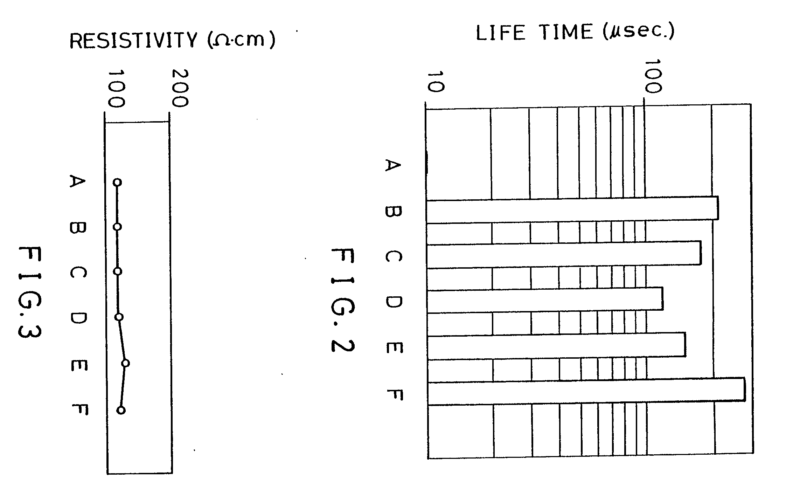

The experimental conditions are the same as those described in the above Table 1. The results of the experiment are summarized in Figs. 2 and 3. The axis of abscissa indicates the experimental conditions A F of Table 1. The axis of ordinate shows the life time (in $\mu$ sec.) in Fig. 2 and the resistivity (in $\Omega$ cm) Fig. 3.

In A of Fig. 2, the life time was too short and was the same as the noise level. When A in Fig. 2 is compared with B - E, it is made clear that the life time is increased by 100 - 200 times if annealed in a nitrogen atmosphere.

From the results of the above Experiment 1, the reasons for the increase in the life time can be reckoned as follows: When a Si surface is changed to $SiO_2$, volume is increased and stress is generated in the interface between the two. Thus, the uncoupled bonds of Si are increased near the interface and the recombination rate of the surface is increased. In $N_2$ anneal, nitrogen comes to the vicinity of the interface due to the above-mentioned stress and part of nitrogen work to reduce the number of uncoupled bonds of Si atoms through chemical coupling. This is also supported by the finding that the life time extremely differs according to whether nitrogen is placed in the atmosphere or not (A, F).

On the other hand, it is anticipated that N atom becomes the donor if the substitutes Si atom in the lattice because N belongs to the Group V of elements like P and As. However, it was found that the resistivity does not change even when nitrogen is concentrated highly near the interface between Si and $SiO_2$.

This reveals that N atoms concentrated near the interface are bonded in an electrically inert state. Thus, electrical property is not adversely affected.

The method according to the present invention is effective not only for the stabilization of the properties of oxidized films in other cases, e.g. the evaluation of optimal condition for annealing in the atmosphere of nitrogen compound gas, but also for the determination of optimal conditions for the annealing of crystallographic distortion on or near the surface of silicon substrate by ion implantation, plasma etching, etc.

The present invention provides the good effects on evaluating the optimal conditions of the annealing in nitrogen atmosphere of thermally oxidized silicon single crystal substrate by the measurement of life time and is effective for the stabilization and homogenization of the semiconductor physical property in the interface of oxidized film and silicon. It also contributes extensively to the in-line quality control of the manufacturing process of semiconductor devices.

## Claims

1) A method to evaluate the degree of stabilization and homogenization of the property of the interface by measuring the life time of the thermally oxidized silicon substrate in the process to stabilize and homogenize the properties of the interface between the oxidized film and the substrate by annealing in nitrogen atmosphere in the manufacture of semiconductor device having MOS structure.

2) A method as set forth in Claim (1), wherein microwave is steadily irradiated on the surface of said semiconductor substrate, the intensity of the reflected wave is detected, the carrier is generated in said substrte by irradiating optical pulse to said irradiated portion during irradiation of said microwave, and said life time is measured based on the changes in said detected intensity due to the irradiation of said optical pulse.

3) A method as set forth in Claim (1), wherein microwave is steadily irradiated on the surface of said semiconductor substrate, the intensity of the transmitted wave is detected, the carrier is generated in said substrate by irradiating optical pulse to said irradiated portion during irradiation of said microwave, and said life time is measured based on the changes of said detected intensity due to the irradiation of said optical pulse.

F I G. 1

F I G. 2

F I G. 3